# EUROPEAN PATENT APPLICATION

(11) **EP 3 043 063 A1**
(43) Date of publication of application: **13.07.2016**
(21) Application number: 15150486.7
(22) Date of filing: 08.01.2015
(51) Int. Cl.: F03D 13/00, G01R 31/34, H02J 3/38, F03D 9/00

(54) **Islanded testing of a wind turbine generators compliance with fault ride through requirements of a power grid**

(71) Applicant: Siemens Aktiengesellschaft, 80333 München (DE)
(72) Inventor: Kumar, Sathees, 7400 Herning (DK)

(57) **Abstract**

There is described an apparatus for testing compliance of a wind turbine generator with fault ride through requirements of a power grid to which the wind turbine generator is to be connected. The apparatus comprises (a) a terminal unit for connecting with a power output of the wind turbine generator that is to be tested, (b) a synchronous generator coupled to the terminal unit and adapted to set up a predetermined alternating voltage at the terminal unit, and (c) a fault unit for applying a predetermined fault at the terminal unit. There are further described a method of testing by use of such apparatus as well as a method of manufacturing the apparatus.

## Description

### Field of Invention

The present invention relates to the field of testing of wind turbine generators, in particular to an apparatus for testing compliance of a wind turbine generator with fault ride through requirements of a power grid to which the wind turbine generator is to be connected, a corresponding method of testing, and a method of manufacturing such apparatus.

### Art Background

When new WTGs (wind turbine generators) are about to get into the market, it is highly important that the WTGs are able to be grid compliant. The Transmission System Operator (TSO), who is responsible for operating the electrical grid in a country or state, puts up several requirements for WTGs with regard to how these should respond to various grid faults without tripping, such as for instance temporary voltage drops or increases in the grid. These are the so called FRT (Fault Ride Through) requirements.

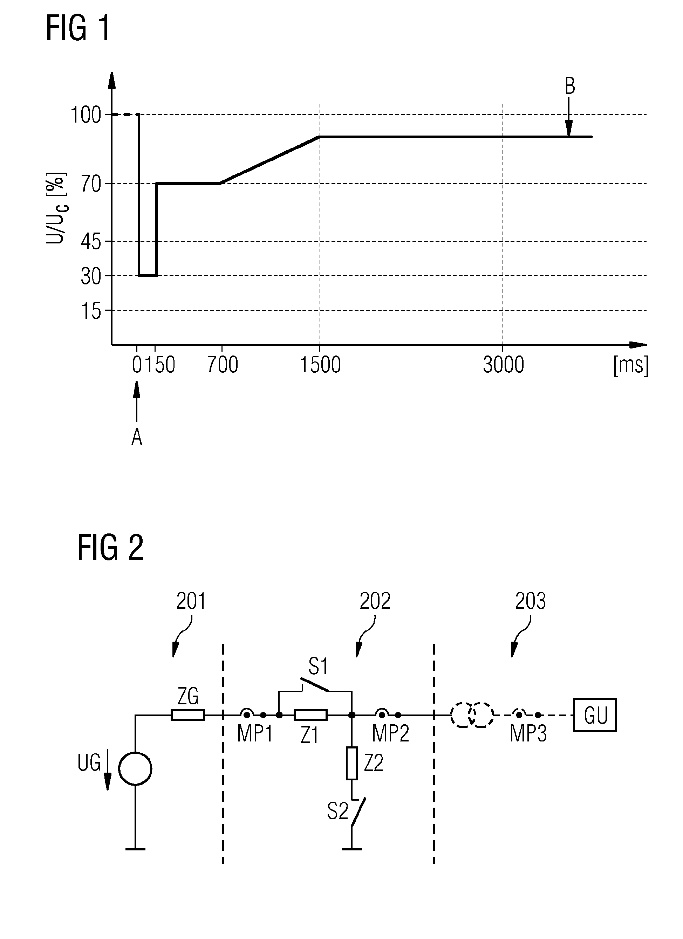

An example of such an FRT requirement is shown in Figure 1, where the y-axis represents the voltage (as percentage) and the x-axis represents time (in milliseconds). As shown, a WTG should be able to "survive" a voltage dip down to 30% of nominal voltage (occurring at time equal to zero as indicated by arrow A) for up to 150 milliseconds. The arrow B indicates the lower limit of the voltage range.

When a new WTG with a new converter is about to be introduced, it is a requirement that the manufacturer can perform the necessary tests in order to validate that the new WTG is actually able to fulfill the relevant FRT grid code.

Until now, the normal procedure for conducting FRT tests is as follows:
1. Find a site with the right WTG and converter
2. Obtain permission to perform the FRT testing from client or TSO
3. Update the converter software with the test software
4. Perform the FRT measurements
5. Document the measurements in a report that is sent to a certification partner
6. Get a certification from an external party that certifies that the tested WTG complies with the grid code.

However, the above testing scheme may have a negative impact on the grid and thereby cause undesirable grid disturbances. As an example, voltage dips that are artificially created during FRT testing may propagate in the nearby area such that the corresponding voltage also drops because of the tests. Such grid voltage drops are highly undesirable.

Figure 2 illustrates how FRT testing is currently done on a single WTG 201 by connecting an FRT test container 202 between the test WTG 201 and the external grid 203.

The FRT test unit 202 comprises impedances Z1, Z2 and switches S1, S2. These can be configured in such a way that the voltage at the terminals of WTG 201 can be controlled to exhibit a specific dip magnitude for a predetermined period of time. Thereby, it can e.g. be tested whether the WTG 201 is capable of handling the voltage dip illustrated in Figure 1.

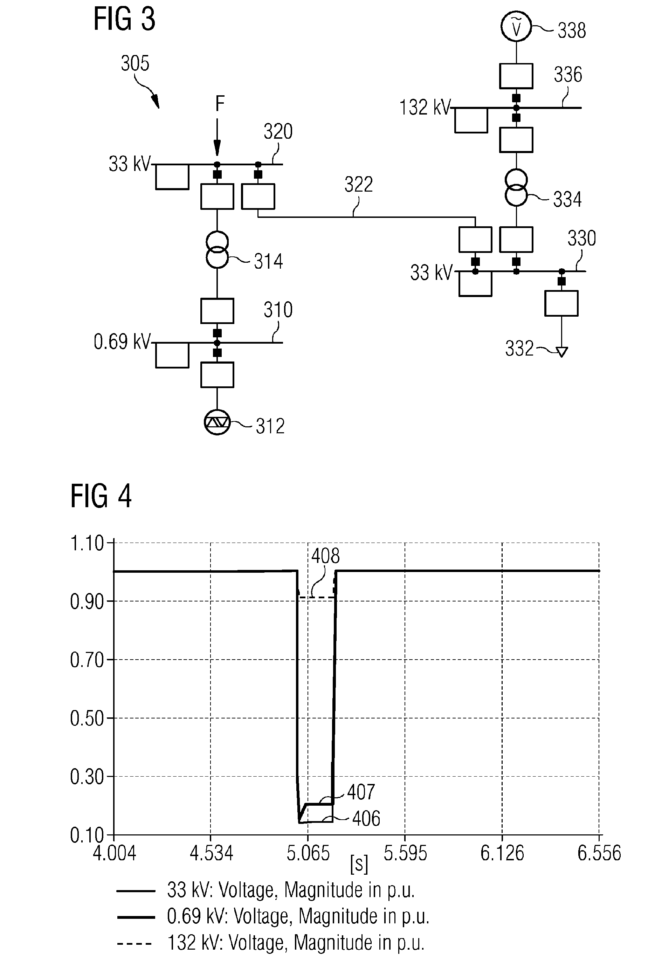

However, as already mentioned above, causing a voltage dip during testing will affect the voltage at other places in the grid as well. This problematic is illustrated in more detail in Figures 3 and 4.

Figure 3 shows an exemplary model of a WTG 312 connected to a 0.69 kV bus bar 310 which in turn is coupled to a 33 kV bus bar 320 via transformer 314. The 33 kV bus bar 320 is connected to a 33 kV bus bar 330 at the grid side through cable 322, such as a 10 km long subsea cable. The grid side 33 kV bus bar 330 is connected to a general load 332 and coupled to a 132 kV bus bar 336 through step-up transformer 334. The 132 kV bus bar 336 is connected to the grid 338 which is represented as a Thevenin source.

Figure 4 shows the consequences of applying a fault in terms of a voltage dip at the 33 kV bus bar 320 (as indicated by arrow F in Figure 3). More specifically, Figure 4 shows a plot of the voltage 406 at the 33 kV bus bar 320, a plot of the voltage 407 at the 0.69 kV bus bar 310, and a plot of the voltage 408 at the 132 kV bus bar 336. All three plots show the corresponding voltages 407, 407 and 408 as functions of time.

It is evident from the plots in Figure 4 that the voltage 408 at the 132 kV bus bar 336 is significantly affected by the fault applied at the 33 kV bus bar 320. In the case shown in Figure 4, the voltage 408 dips to about 90% during the fault applied at the 32 kV bus bar 320. In view of this, transmission system operators may have strong reservations towards allowing performance of the FRT testing due to negative impact on the adjacent grid, which may result in complaints from the grid customers, such as households, factories and other power consumers.

Thus, there may be a need for a way of performing FRT tests without negatively affecting the external grid.

### Summary of the Invention

This need may be met by the subject matter according to the independent claims. Advantageous embodiments of the present invention are set forth in the dependent claims.

According to a first aspect of the invention, there is provided an apparatus for testing compliance of a wind turbine generator with fault ride through requirements of a power grid to which the wind turbine generator is to be connected. The apparatus comprises (a) a terminal unit for connecting with a power output of the wind turbine generator that is to be tested, (b) a synchronous generator coupled to the terminal unit and adapted to set up a predetermined alternating voltage at the terminal unit, and (c) a fault unit for applying a predetermined fault at the terminal unit.

This aspect of the invention is based on the idea that the wind turbine to be tested is connected to a synchronous generator via a terminal unit instead of to the external power grid and that a predetermined fault is applied at the terminal unit such that it can be observed how the wind turbine generator reacts to the fault and, in particular, whether the wind turbine generator complies with the fault ride through requirements of the power grid to which the wind turbine is eventually to be connected. In this way, the wind turbine generators reaction to the fault can be observed without causing disturbances in the power grid. Furthermore, the testing of the wind turbine generator may take place at any desired location as it is not necessary to actually connect to the relevant power grid.

In the present context, the term "terminal unit" may in particular denote any means suitable for providing electrical connection or coupling between a synchronous generator and a wind turbine generator. In embodiments of the present invention, the "terminal unit" may be implemented as a bus bar. The synchronous generator may e.g. be a diesel generator or a similar generator that is capable of providing a predetermined alternating voltage, i.e. an alternating voltage with given magnitude and frequency.

The fault unit is capable of applying a predetermined fault at the terminal unit in the sense that the predetermined alternating voltage provided by the synchronous generator is disturbed for a certain period of time in order to emulate the conditions during a particular fault situation specified by the fault ride through requirements of the relevant power grid.

According to an embodiment of the invention, the predetermined alternating voltage corresponds to a nominal alternating voltage of the power grid to which the wind turbine generator is to be connected.

In other words, the synchronous generator is configured to generate an alternating voltage with the magnitude and frequency that are specified as nominal values for the relevant power grid.

Thereby, when the wind turbine generator that is to be tested is connected to the terminal unit, it will experience substantially the same situation as if it were in fact connected to the power grid.

According to a further embodiment of the invention, the synchronous generator comprises a controller for controlling the voltage and/or the frequency of the predetermined alternating voltage.

The controller provides similar stability with regard to voltage and/or frequency as may be expected from a true power grid.

According to a further embodiment of the invention, the apparatus further comprises a load for absorbing electric power supplied by the wind turbine generator.

Thus, the load may ease operation of the synchronous generator as the latter will not have to deal with the power supplied by the wind turbine generator.

According to a further embodiment of the invention, the load is adapted to absorb active power and/or reactive power.

According to a further embodiment of the invention, the load comprises a load controller for controlling the load in dependence of the power supplied by the wind turbine generator such that the synchronous generator is substantially unloaded.

By controlling the load (e.g. by adjusting an impedance of the load) in dependency of the power from the wind turbine generator, it can be assured that synchronous generator is substantially unloaded independently of the exact amount of power produced by the wind turbine generator. Accordingly, the synchronous generator will only have to supply the predetermined alternating voltage.

According to a further embodiment of the invention, the fault unit is adapted to apply a voltage dip as the fault at the terminal unit.

More specifically, the voltage dip causes the voltage at the terminal unit to decrease to a predetermined fraction of the predetermined alternating voltage for a predetermined duration of time.

The predetermined fraction and the predetermined duration are preferably determined in accordance with the relevant fault ride through requirements.

According to a further embodiment of the invention, the fault unit comprises a voltage divider and at least one switch for selectively connecting and disconnecting the voltage divider between the synchronous generator and the terminal unit.

The voltage divider is a simple and efficient way of reducing the voltage at the terminal unit to a predetermined fraction. By carefully controlling the switch that connects and disconnects the voltage divider, the duration of the voltage dip can also be controlled with high precision.

According to a further embodiment of the invention, the fault unit is adapted to apply an overvoltage as the fault at the terminal unit.

In the present context, the term "overvoltage" may in particular denote a fault where the voltage at the terminal unit increases above the nominal voltage of the grid for a certain period of time.

According to a further embodiment of the invention, the fault unit comprises a shunt capacitor for selectively increasing the voltage at the terminal unit.

The shunt capacitor may be connected and disconnected in a selective manner, e.g. by means of a switch, to inject reactive power into the terminal unit for a predetermined period of time, such that the voltage increases above the predetermined voltage level for a predetermined period of time.

By observing the behavior of the wind turbine generator during and/or after said predetermined period of time, it may be determined whether the wind turbine is capable of withstanding the corresponding fault in a satisfactory manner.

According to a second aspect of the invention, there is provided a method of testing compliance of a wind turbine generator with fault ride through requirements of a power grid to which the wind turbine generator is to be connected. The method comprises (a) providing an apparatus according to the first aspect or any of the above embodiments, (b) connecting the power output of the wind turbine generator to the terminal unit of apparatus, (c) operating the apparatus to apply a predetermined fault at the terminal unit, (d) monitoring the behavior of the wind turbine generator relative to the applied fault, and (e) determining whether the behavior of the wind turbine generator complies with the fault ride through requirements of the power grid.

This aspect of the invention is essentially based on the same idea as the first aspect described above and comprises the use of an apparatus according to the first aspect.

According to a third aspect of the invention, there is provided a method of manufacturing an apparatus for testing compliance of a wind turbine generator with fault ride through requirements of a power grid to which the wind turbine generator is to be connected. The method comprises (a) providing a terminal unit for connecting with a power output of the wind turbine generator that is to be tested, (b) providing a synchronous generator and coupling it to the terminal unit, wherein the synchronous generator is adapted to set up a predetermined alternating voltage at the terminal unit, and (c) providing a fault unit for applying a predetermined fault at the terminal unit.

This aspect of the invention is based on essentially the same idea as the first and second aspects described above and more specifically constitutes a method of manufacturing an apparatus according to the first aspect.

Summarizing, the present invention provides a way of testing a wind turbine generator for compliance with fault ride through requirements of a power grid without actually connecting the wind turbine generator with the power grid. Thereby, grid disturbances caused by the testing can be avoided and the testing may be performed at a site remote from the power grid.

It is noted that embodiments of the invention have been described with reference to different subject matters. In particular, some embodiments have been described with reference to method type claims whereas other embodiments have been described with reference to apparatus type claims. However, a person skilled in the art will gather from the above and the following description that, unless otherwise indicated, in addition to any combination of features belonging to one type of subject matter also any combination of features relating to different subject matters, in particular to combinations of features of the method type claims and features of the apparatus type claims, is part of the disclosure of this document.

The aspects defined above and further aspects of the present invention are apparent from the examples of embodiments to be described hereinafter and are explained with reference to the examples of embodiments. The invention will be described in more detail hereinafter with reference to examples of embodiments. However, it is explicitly noted that the invention is not limited to the described exemplary embodiments.

### Brief Description of the Drawing

Figure 1 shows exemplary fault ride through requirements with regard to a voltage dip.
Figure 2 shows a structural diagram of a known system for testing for compliance with fault ride through requirements.
Figure 3 shows a schematic diagram of a wind turbine generator that is connected to a power grid while testing for compliance with fault ride through requirements.
Figure 4 shows plots of the voltage at various points in the diagram of Figure 3 during testing.
Figure 5 shows a schematic diagram of a system for testing a wind turbine generator for compliance with fault ride through requirements in accordance with an embodiment of the present invention.
Figure 6 shows plots of the voltage at various points in the diagram of Figure 5 during testing.
Figure 7 shows a graph illustrating a fault ride through requirement with regard to overvoltage.
Figure 8 shows a schematic diagram of a system for testing a wind turbine generator for compliance with fault ride through requirements in accordance with an embodiment of the present invention.
Figure 9 shows plots of the voltage at various points in the diagram of Figure 8 during testing.

### Detailed Description

The illustration in the drawing is schematic. It is noted that in different figures, similar or identical elements are provided with the same reference numerals or with reference numerals which differ only within the first digit.

The illustrations of Figures 1 to 4 are discussed in the background section.

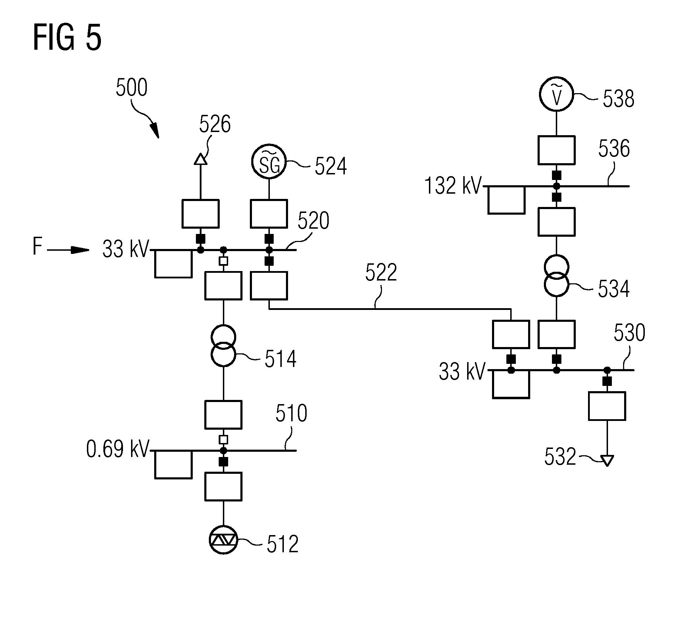

Figure 5 shows a schematic diagram of a system 500 for testing a wind turbine generator 512 for compliance with fault ride through requirements in accordance with an embodiment of the present invention. More specifically, Figure 5 shows an exemplary model of a WTG 512 connected to a 0.69 kV bus bar 510 which in turn is coupled to a 33 kV bus bar 520 via transformer 514. Furthermore, a synchronous generator 524 and a load 526 are coupled to bus bar 520. The synchronous generator 524 is driven by a small genset, such as a diesel generator. The load 526 may comprise a resistor bank or any other suitable impedance structure. The wind turbine generator 512 may be tested for compliance with fault ride through requirements by applying a fault condition to bus bar 520 as indicated by the arrow F. This may be done by activating a fault unit (not shown) in order to influence the voltage at bus bar 520 for a predetermined amount of time. For example, the wind turbine generator's reaction to a short voltage dip may be tested by using a fault unit corresponding to the voltage divider shown in Figure 2. The load 526 serves to absorb (active and/or reactive) power delivered by the wind turbine generator 512 such that the synchronous generator 524 is substantially unloaded during testing.

Figure 5 further shows that the 33 kV bus bar 520 is connected to a 33 kV bus bar 530 at the grid side through cable 522, such as a 10 km long subsea cable. However, it is explicitly noted that this is not necessary for carrying out the testing in accordance with the present invention. In fact, if present, the cable 522 should be disconnected before testing. The grid side 33 kV bus bar 530 is connected to a general load 532 and coupled to a 132 kV bus bar 536 through step-up transformer 534. The 132 kV bus bar 536 is connected to the grid 538 which is represented as a Thevenin source.

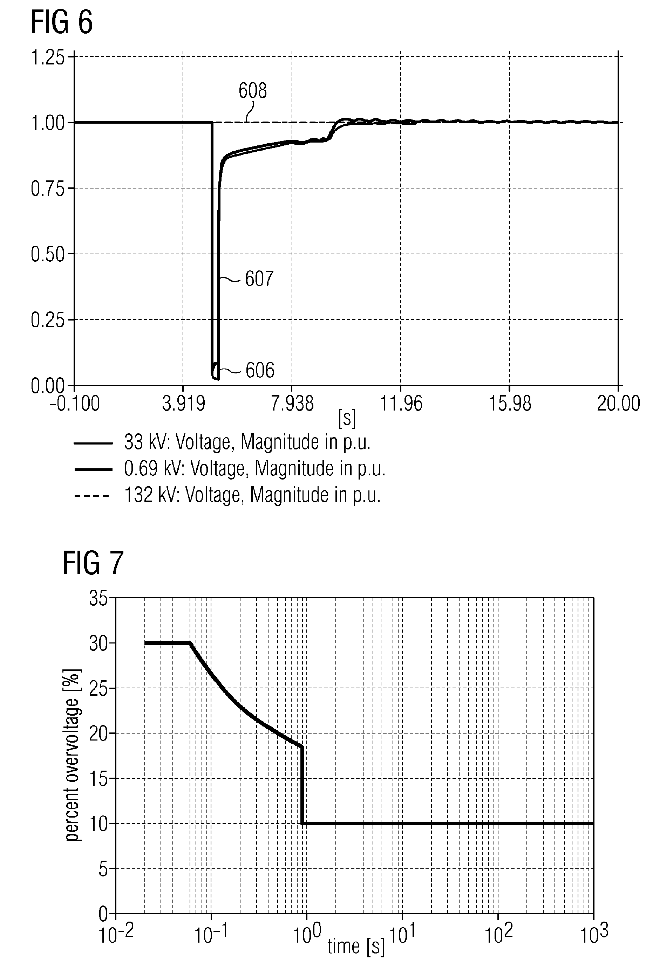

Figure 6 shows the consequences of applying a fault in terms of a voltage dip at the 33 kV bus bar 520 (as indicated by arrow F in Figure 5). More specifically, Figure 6 shows a plot of the voltage 606 at the 33 kV bus bar 520, a plot of the voltage 607 at the 0.69 kV bus bar 510, and a plot of the voltage 608 at the 132 kV bus bar 536. All three plots show the corresponding voltages 607, 607 and 608 as functions of time.

It is evident from the plots in Figure 6 that the voltage 608 at the 132 kV bus bar 536 is completely unaffected by the fault applied at the 33 kV bus bar 520. As can be seen, the voltage 608 shows no dip but remains at 100% during the fault applied at the 32 kV bus bar 520. Thus, it is confirmed that the present invention allows FRT without negative impact on the operating power grid.

Figure 7 shows a graph illustrating a fault ride through requirement with regard to overvoltage in Australia. As can be seen, the wind turbine generator is required to withstand an overvoltage of 30% for a short period of time.

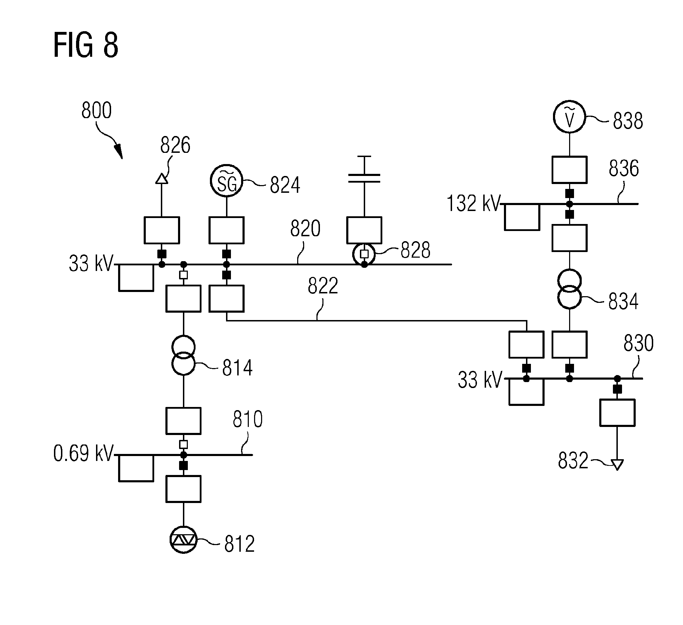

Figure 8 shows a schematic diagram of a system 800 for testing a wind turbine generator for compliance with fault ride through requirements in accordance with an embodiment of the present invention. More specifically, the system 800 is configured for testing compliance with fault ride through requirements relating to overvoltage, such as the requirement shown in Figure 7. The system 800 is very similar to the system 500 shown in Figure 5 and discussed above, but differs therefrom by the addition of a shunt capacitor 828 which may be connected to bus bar 820 (e.g. by means of a suitable switch) in order to inject reactive power and thereby raise the voltage at the bus bar 820 beyond the voltage provided by the synchronous generator 824.

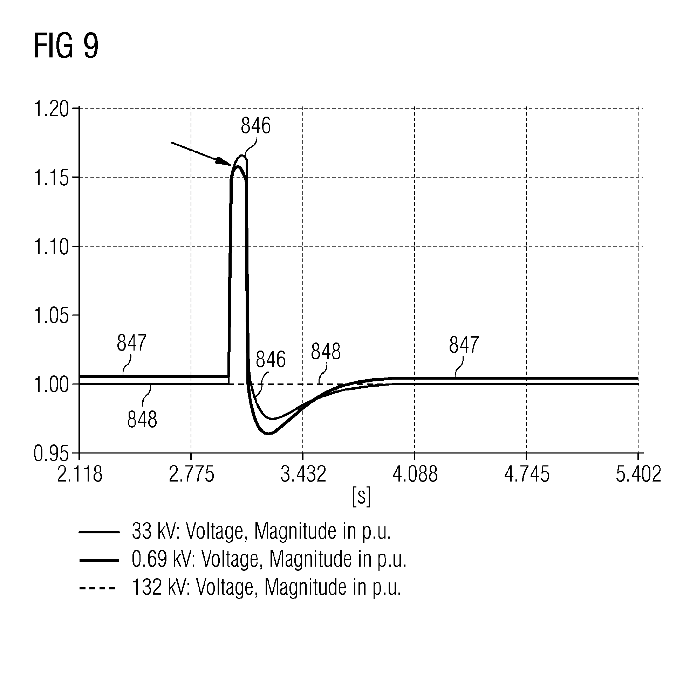

Figure 9 shows plots of the voltage at various points in the diagram of Figure 8 during testing. More specifically, the plot shows the voltage 846 at the bus bar 820, the voltage 847 at the bus bar 810, and the voltage 848 at the bus bar 836. As can be seen, the shunt capacitor 828 is switched in at t = 3 seconds and switched out again at t = 3.1 seconds. The peak of the overvoltage is about 116% of the nominal voltage (as indicated by an arrow) and the two bus bar voltages 846 and 847 follow each other closely, while the voltage 848 at the bus bar 836 in the power grid remains stable.

As can be seen from the above, the present invention provides an efficient way of testing a wind turbine generator's compliance with fault ride through requirements where the wind turbine generator is islanded (i.e. disconnected from the power grid). First of all, this provides the advantage that the testing does not cause disturbances in the grid. Furthermore, the testing can be conducted at a site far away from the power grid.

It is noted that the term "comprising" does not exclude other elements or steps and the use of the articles "a" or "an" does not exclude a plurality. Also elements described in association with different embodiments may be combined. It is further noted that reference signs in the claims are not to be construed as limiting the scope of the claims.

## Claims

1. An apparatus for testing compliance of a wind turbine generator with fault ride through requirements of a power grid to which the wind turbine generator is to be connected, the apparatus comprising
a terminal unit for connecting with a power output of the wind turbine generator that is to be tested,
a synchronous generator coupled to the terminal unit and adapted to set up a predetermined alternating voltage at the terminal unit, and
a fault unit for applying a predetermined fault at the terminal unit.

2. The apparatus according to the preceding claim, wherein the predetermined alternating voltage corresponds to a nominal alternating voltage of the power grid to which the wind turbine generator is to be connected.

3. The apparatus according to any of the preceding claim, wherein the synchronous generator comprises a controller for controlling the voltage and/or the frequency of the predetermined alternating voltage.

4. The apparatus according to any of the preceding claims, further comprising a load for absorbing electric power supplied by the wind turbine generator.

5. The apparatus according to the preceding claim, wherein the load is adapted to absorb active power and/or reactive power.

6. The apparatus according to claim 4 or 5, wherein the load comprises a load controller for controlling the load in dependence of the power supplied by the wind turbine generator such that the synchronous generator is unloaded.

7. The apparatus according to any of the preceding claims, wherein the fault unit is adapted to apply a voltage dip as the fault at the terminal unit.

8. The apparatus according to the preceding claim, wherein the fault unit comprises a voltage divider and at least one switch for selectively connecting and disconnecting the voltage divider between the synchronous generator and the terminal unit.

9. The apparatus according to any of the preceding claims, wherein the fault unit is adapted to apply an overvoltage as the fault at the terminal unit.

10. The apparatus according to the preceding claim, wherein the fault unit comprises a shunt capacitor for selectively increasing the voltage at the terminal unit.

11. A method of testing compliance of a wind turbine generator with fault ride through requirements of a power grid to which the wind turbine generator is to be connected, the method comprising
providing an apparatus according to any of the preceding claims,
connecting the power output of the wind turbine generator to the terminal unit of apparatus,
operating the apparatus to apply a predetermined fault at the terminal unit,
monitoring the behavior of the wind turbine generator relative to the applied fault, and
determining whether the behavior of the wind turbine generator complies with the fault ride through requirements of the power grid.

12. A method of manufacturing an apparatus for testing compliance of a wind turbine generator with fault ride through requirements of a power grid to which the wind turbine generator is to be connected, the method comprising
providing a terminal unit for connecting with a power output of the wind turbine generator that is to be tested,
providing a synchronous generator and coupling it to the terminal unit, wherein the synchronous generator is adapted to set up a predetermined alternating voltage at the terminal unit, and
providing a fault unit for applying a predetermined fault at the terminal unit.
